# EUROPEAN PATENT APPLICATION

(11) **EP 4 687 027 A1**
(43) Date of publication of application: **04.02.2026**
(21) Application number: 24191900.0
(22) Date of filing: 30.07.2024
(51) Int. Cl.: G06F 7/60, G11C 16/34, H03K 21/40

(54) **A COUNTER WITH LOW MEMORY DEMAND**

(71) Applicant: NXP B.V., 5656 AG Eindhoven (NL)
(72) Inventor: Ostertun, Soenke, 5656 AG Eindhoven (NL); Hafkemeyer, Kristian, 5656 AG Eindhoven (NL)
(74) Representative: Krott, Michel

(57) **Abstract**

There is described a computer-implemented method of operating a counter, the method comprising:
i) performing a counting operation, wherein the counting operation is done in a bit-wise manner, in particular using Gray code;
ii) splitting the counting operation using a wear levelling; and
iii) performing an error correction scheme with respect to the counting operation using a majority voting.

## Description

### TECHNICAL FIELD

The present disclosure relates to a computer-implemented method of operating a counter, the method comprising: performing a counting operation, wherein the counting operation is done in a bit-wise manner using Gray code, splitting the counting operation using wear levelling, and performing an error correction scheme with respect to the counting operation using majority voting. The present disclosure further relates to a counter device that comprises at least one logic circuit, in particular a processor, configured to perform said method. The present disclosure further relates to a device with a non-volatile storage and said counter device.

The disclosure may hence relate to the technical field of counter devices, in particular in the context of non-volatile memories.

### TECHNICAL BACKGROUND

Counter devices are well-known electronic or digital devices used to count occurrences of events, objects, or processes. Counter devices may thus be seen as fundamental components in electronic and digital processes and are widely used in applications ranging from simple event counting to complex digital systems. Even though a counter may be seen as a simple counting machine, its memory demand, specifically in view of data security, can be enormous.

As an example, if a counter is considered which shall get incremented every minute and the product lifetime is ten years, such a counter would need to get > 5*10⁶ updates. Now assuming that the memory supports at maximum 25.000 updates per bit (endurance specification), more than 200 locations in the memory would be required as a consequence to ensure that the endurance specification is not violated.

It is a known concept for counters that the counting operation/process is split in a low part (bits that are frequently changing) and a high part (bits that are not frequently changing). A straightforward implementation of a counter may e.g. split 23 bits (which are needed to represent 5-6 million states) into 8 bits for the high part and 15 bits for the low part. The high part can be used as an index into an array of 200 to 256 instances of the low part. The low part can count from 0 to 24.999, and the next counter update would increment the high part from 0 to 1 and hence move to the second location for the low part. If all low part locations are already initialized to 0, the performance is not impacted, as updating the high part does normally not require any update of the low part. The drawback of this approach would nevertheless be a high memory demand.

Instead of using a binary representation, a Gray code could be used. Gray codes only change the value of a single bit at each increment. By this, the total number of bit updates is significantly less. For example, a Gray code sequence using three bits can count as follows: 000, 001, 011, 010, 110, 111, 101, 100 (one counting cycle). A standard Gray code toggles the least significant bit (of the low part) every second time. Thus, an endurance of 25.000 updates would allow for 50.000 updates of a Gray counter. Using such an approach would reduce the memory demand by around 50%.

Another advantage of using Gray-codes may be the consequence of the single-bit update per increment: if an update is interrupted, it will be either reflect the previous/old or the new value. In case of tearing, it cannot jump to any other counter value, while a binary counter update can easily jump arbitrarily (e.g. from 15 to 16 may result in 0 or 31), if setting and clearing of bits is done sequentially and tearing may interrupt an intermediate state. It follows that the application of Gray codes can provide advantages over binary code counting.

However, technically and economically important memories that allow individual bit toggling in both directions (e.g. RRAM, MRAM, PC-RAM, FE-RAM; not FLASH which can only erase a plurality of bits simultaneously) are typically not error free and require an error correction scheme.

Gray codes simply do not work in conjunction with standard error correction schemes (e.g. Hamming, BCH), which are needed on said emerging memories like RRAM, MRAM, etc. Conventional error correction schemes are calculating additional parity bits which get stored in addition to the payload data in the non-volatile memory. A single-bit update of the payload requires at least two bits to get updated in the parity section. As a consequence, the number of updates in the parity bits is equivalent to the number of updates in a binary counter and the advantage of the Gray code could then not be utilized.

### SUMMARY OF THE DISCLOSURE

There may be a need to provide an efficient and reliable counter with low memory demand. A method, a counter device, a device, and a method of using are provided.

According to an aspect of the present disclosure, it is described a (computer-implemented) method of operating a counter (device), the method comprising:
i) performing a counting operation (in other words: count by updating/incrementing the counter, e.g. count one or more counting cycles), wherein the counting operation is done in a bit-wise manner, for example using Gray code (an established scheme of changing/toggling only/exclusively one bit per increment) or Thermometer code;
ii) splitting/distributing the counting operation using wear levelling (e.g. distribute the counting operation in different locations of a memory); and
iii) performing an error correction scheme with respect to the counting operation using majority voting (for example, perform each increment three times separately and correct based on the majority result).

According to a further aspect of the present disclosure, it is described a counter device, comprising at least one logic circuit, in particular a processor, configured to perform the method described above.

According to a further aspect of the present disclosure, it is described a device, comprising:
i) a non-volatile storage/memory with individual bit (bit-wise) update, and
ii) a counter device as described above,
wherein the counter device is at least partially integrated in the non-volatile storage.

According to a further aspect of the present disclosure, it is described a use (method of using) of the method and/or the counter device to reduce memory demand of a counting operation.

In the context of the present document, the term "Gray code" may in particular refer to an established specific binary system, where two successive values differ in only one bit. In other words, counting comprises changing exclusively one bit per increment. For example, a Gray code may operate/count according to a specific Gray code sequence, e.g. 000, 001, 011, 010, 110, 111, 101, 100. Counting one such sequence may be termed in this context a counting cycle. In an example, the Gray code sequence may also be counted backwards (decrement). In a further example, the bit positions of the Gray code may be shifted ("rotated") to distribute the use of bits more efficiently.

In the context of the present document, the term "Thermometer code" may in particular refer to a further established specific binary system, where two successive values differ in only one bit. In an example, with n bits, 2*n values can get represented; e.g. 4 bits may count as 0000, 0001, 0011, 0111, 1111, 1110, 1100, 1000, [0000]. The Thermometer code may provide a comparable advantage as Gray code by single-big toggling, and majority voting may be applied in a comparable manner. The total memory need may also be comparable: i) more memory demand for thermometer-coded word, but higher re-use, ii) less memory demand for Gray-coded low-word, but more re-location needed for wear-levelling. The ratio for both may be comparable or even the same.

In the context of the present document, the term "wear levelling" may in particular refer to a technique of evenly/regularly distribute counting across memory locations, in particular between individual bits. Thereby, the lifetime of a non-volatile memory may be increased (endurance requirement). By ensuring that no single memory location is subjected to excessive use by counter updates, wear levelling may prevent premature memory failure.

In the context of the present document, the term "majority voting" may in particular refer to an error correction scheme, where multiple (e.g. three or more) redundant bits/counters are used. The final count value may be determined by taking the majority value from these redundant bits/counters, thereby mitigating the impact of potential errors in individual bits/counters.

According to an exemplary embodiment, the disclosure may be based on the idea that an efficient and reliable counter with low memory demand can be provided, when a bit-wise counting scheme (in the following, Gray code is used as an example) is combined in conjunction with an optimized wear levelling scheme, and the error correction scheme is implemented by majority voting.

As discussed above, Gray code schemes can normally not be applied in a reasonable manner with respect to established error correction schemes such as Hamming. If the advantages of the Gray code for endurance shall be used, each payload bit needs its own redundancy. For example, majority voting of three raw bits per payload bit would be 1-bit fault-tolerant, while majority voting of five raw bits per payload bit would be 2-bit fault-tolerant. It follows that the application of majority voting, as an error correction scheme of Gray code counting, would increase the memory demand by at least three times (200 %). In contrast to majority voting, error correction schemes like Hamming or BCH codes are more efficient (typically significantly less than +50% memory demand) but are commonly known incompatible to bit-wise counting schemes such as Gray codes.

It has now been surprisingly found that the bit-wise counting schemes like Gray code counting may be combined with wear levelling in such an optimized manner that an enormous decrease in memory demand, in particular considering the number of required bits, may be achieved. In fact, the decrease of memory demand may be so efficient that, even after the additional application of majority voting (thereby increasing the memory demand by at least 200%), the memory demand may be still significantly lower than in conventional approaches. This finding comes as a surprise and may overcome the technical prejudice that Gray code schemes are not suitable for applications that require error correction schemes.

In other words, the present disclosure may combine several techniques to achieve the least memory needs for emerging memories which allow bit-individual updates but require error correction (even double-bit-correction in some cases). Using Gray codes is counter-intuitive, as fault-tolerance asks for bit-individual redundancy and consequently causes a massive increase of memory demand. The present disclosure shows that the overall memory utilization may still be more efficient when using Gray codes with majority voting in conjunction with an optimized wear-levelling scheme compared to binary encoded counters using potentially more efficient error correction schemes.

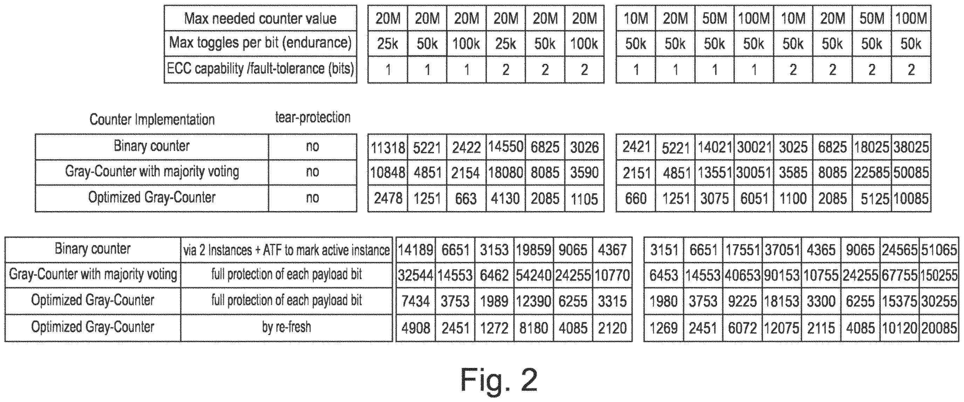

In an illustrative example (compare Figure 2) and referring to the example calculation from above, a binary counter with established error correction (Hamming coded) can be used as a reference with a memory demand of 11.318 bits. A Gray code counter (with 3-bit majority voting and also optimized split of high/low part word size) may be realized with 10.848 bits (compare also Figure 2). One would hence assume that the Gray code advantage is almost cancelled out by the per-bit redundancy needs of the majority voting. However, using the proposed optimized implementation of the present disclosure, the counter may be realized with a memory demand of only 2.478 bits. It follows that the memory utilization is significantly improved, whereby the memory demand is reduced; in this example by around 78%.

The aspects defined above and further aspects of the disclosure are apparent from the examples of embodiment to be described hereinafter and are explained with reference to these examples of embodiment. The disclosure will be described in more detail hereinafter with reference to examples of embodiment but to which the disclosure is not limited.

### EXEMPLARY EMBODIMENTS

According to an embodiment, the bit-wise counting operation comprises at least one of Gray code, Thermometer code. Thus, the counting in a bit-wise manner may be implemented using established and efficient counting schemes.

Gray codes may allow a bit toggling in both directions (bits can get written in both directions individually). Thereby memories such as Flash may be excluded, where erase operations are done page-wise (e.g. kB order) and not bit-wise. Thermometer code, however, may allow bitwise toggling in only one direction, so that memories like Flash may work (e.g. Flash typically provides bitwise programming and page-wise erasing). In an example, a Thermometer code with e.g. only half of the above shown sequence could be used (0000, 0001, 0011, 0111, 1111) plus an erase operation before the next usage. This may cause some additional erase operation on some updates (e.g. when incrementing the high word), but may still enable an advantageous decrease of memory demand in comparison to conventional approaches. In other words, an implementation using Thermometer code may also be feasible on a non-volatile memory that does not allow writing bits in both directions individually, such as Flash.

According to an embodiment, the method further comprises: splitting/distributing the counter operation in a high part and a low part. Thereby, efficiency may be increased, while the memory demand is further decreased.

In an example, splitting the counter is done in the first place by dividing the maximum counter value by the endurance limitation, e.g. 20M/25k = 800. For a conventional binary counter, the straightforward approach would be to dimension the high part/word to support counting to 800 (10 bits wide; +4 parity bits) and reserve 800 locations for wear-levelling of the low part/word (15+5 bits wide to support 25k updates). This sums up to (14+800*20 = 16k). Exchanging the split is achieving better results: by defining the high word to support 25k updates, it needs 15+5 bits and the low part needs to count from 0 to 799; hence the low part needs only 10+4 bits. Per value of the high word, the low word gets only 800 updates, so it can get re-used 31 times (25k/800 rounded down).

Thus, to support the 20M updates, 807 locations for wear-levelling would be needed. This sums up to (20+807*14) 11.318 bits. Hence, the location indexed by either an integer division by 31 (re-use each location until max. endurance before changing the location) or by a modulo division by 807 (move to next location and re-use once all locations have seen 800 updates).

The split may be comparable, if the counter parts are using Gray codes. For standard Gray codes, the least significant bit (LSB) sees still the highest number of updates, i.e. at every second increment. Hence, the number of counter updates is twice the endurance. As for the binary counters, the optimal solution may be the one, where the high word is dimensioned as large as possible to minimize the low word size. Sticking to this example, the high word can get incremented 50.000 times until the endurance limit is reached and hence it needs 16 payload bits or 48 raw memory bits using a 3-bit-majority voting scheme to be 1-bit fault-tolerant. The low word needs to count up to 400 (20M/50k) and it needs 9 payload (27 raw bits). The endurance on the LSB is 200, so that each location can get re-used 125 times (25k/200). To support the 50.000 updates in the high word, 400 locations for wear-levelling of the low word can be needed. This sums up to (48+400*27) 10848 bits.

According to an embodiment, the majority voting comprises a single counting operation. Thus, a single counting operation may be sufficient, thereby saving efforts. In an example, the majority voting counting operation can be re-used for each logical bit. According to another embodiment, the majority voting comprises two or more additional, in particular similar, counting operations. According to an embodiment, the majority voting comprises two or more additional bits (per increment). According to an embodiment, majority voting comprises using two or more, in particular three or more bits per payload bit. In an example, majority voting is done on a per-bit basis and the resulting (corrected) logical bits build then the actual counting scheme (e.g. Gray code). Thereby, redundancy can be provided and the dominant result of three or more values per logical bit allows to obtain the correct counter value. Thereby, a reliable error correction scheme may be provided.

In an example, the majority voting is done on each and every logical bit individually. This may be illustrated by the following example with three instances (A, B, C) having two bits flipped (shown in parentheses).

| | | | | | |
|---|---|---|---|---|---|
| A) | 0 | (0) | 0 | 1 | (flip at index 2) |
| B) | 0 | 1 | 0 | 1 | (fully correct) |
| C) | 0 | 1 | (1) | 1 | (flip at index 1) |

Doing now a majority voting per bit position gives per bit majority (0-2-1-3) = 0 1 0 1 as the correct value.

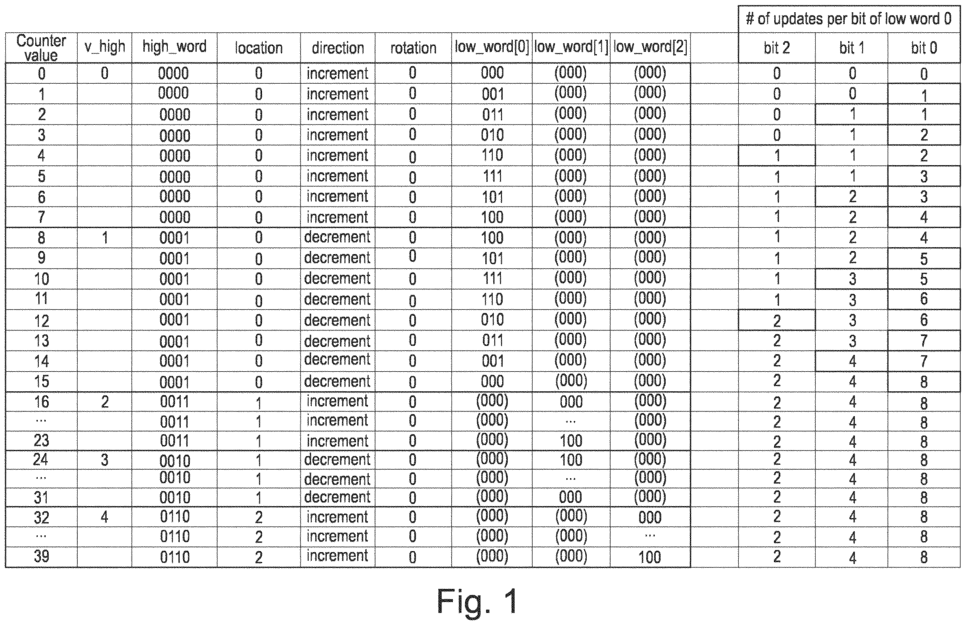

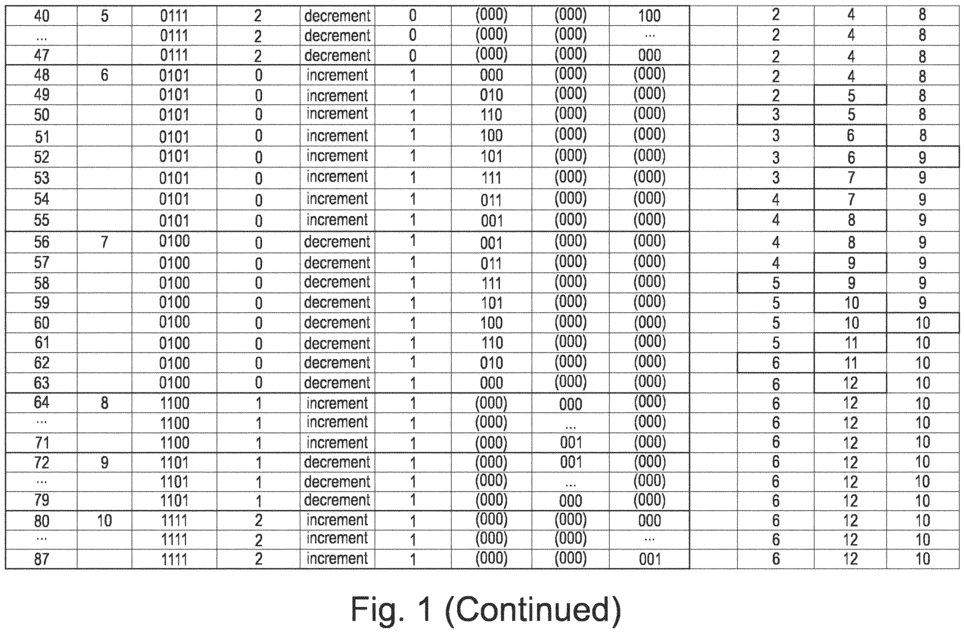

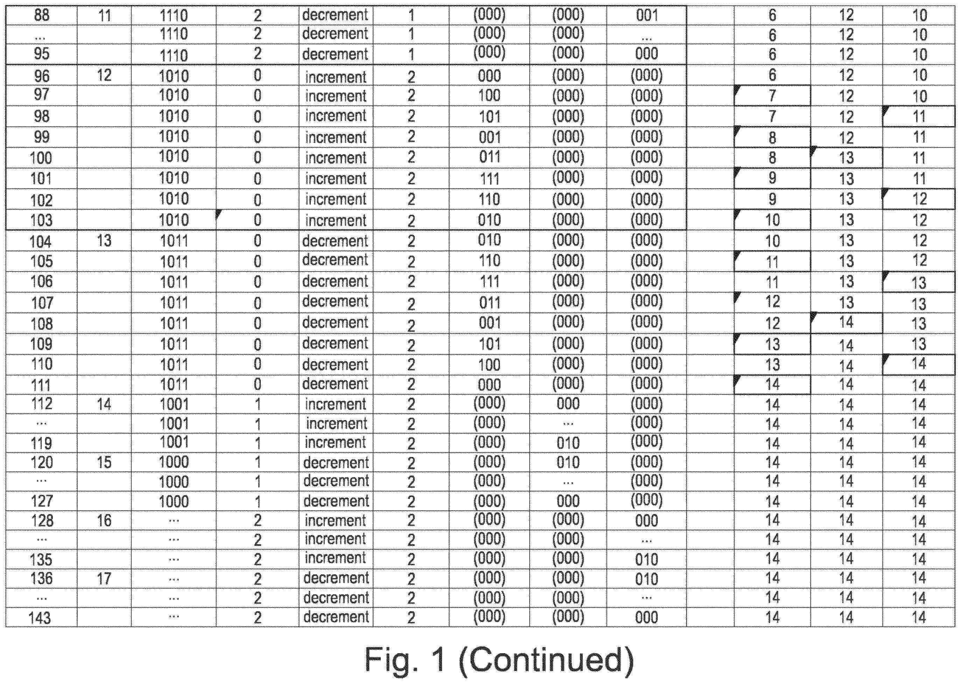

According to an embodiment, wear levelling comprises splitting the counting operation in two or more, in particular three or more locations. In this manner, the counting may be efficiently distributed to meet the endurance requirements. Surprisingly, the wear levelling may be optimized (in conjunction with the Gray code counting) so that for example only three wear leveling locations on the memory are sufficient (e.g. compare the example of Figure 1).

According to an embodiment, the counting operation (in particular wear levelling) comprises a bit rotation scheme, so that a counting process/cycle uses a counting (e.g. Gray code) sequence, wherein at least one bit is different (rotated/shifted) in comparison to the counting (e.g. Gray code) sequence of a previous counting cycle. For example (see also example of Figure 1 for illustration), actually bits are rotated to achieve best wear-levelling inside the low-part. The bit rotation scheme may be implemented to significantly optimize the wear levelling, thereby strongly decreasing the memory demand.

In an example, a rotation scheme inside the low word is used to achieve an improved wear-levelling:
i) when the low word is used at first, the value is used in standard bit assignment: most significant bit (MSB):LSB as stored.
ii) when the low word is used again, the low word is bitwise-rotated by one bit position.
iii) when the low word is then used again, the bit gets rotated by two positions (in the example of Figure 1, three bits and three rotations are used).

In an example, a counter having a width of n bits and using a standard Gray code, may toggle the MSB n-1 once when counting from 0 to 2ⁿ-1, the next bit twice, [...] and the LSB 2ⁿ⁻¹ times. Using this rotation scheme, all bits may have seen 2*2ⁿ⁻¹-1=2ⁿ-1 toggles after n rotations. Thus, the counter width as a function of endurance is the same as for a conventional binary counter, but the same endurance is reached after n-fold usage instead of single usage.

In an example, the high word can support 50k updates without rotation as described above. The low word instead must e.g. support 400 counts, so it needs 9 bits. The advantage of the rotation can now be, that the counter can be reused nine times before all 9 bits got updated exactly 400 times. With the given endurance of 25k, the 9-fold reuse can be re-used 62 times, so each location can support 62*9 = 558 iterations in total and only 90 locations are needed to support the full 20 million updates (50k of high word/588 iterations). Hence, the memory demand is then only (16+90*9) = 826 payload bits. With additional 3-bit majority voting, 2478 raw bits would be required in total, i.e. significantly less than for a conventional binary counter.

In an example, the same split of 16 bits for the high word, and 9 bits for the low word, may also be used to enlarge the full coding space (512 values) of the Gray code. 9-fold reusage of the low word will lead to 512 updates of all bits in the low word, while the high word needs to count only up to 39.062 (20M/512). With the given endurance of 25k, the 9-fold reuse may be re-used 48 times and the number of needed locations may be almost identical (39.062/9/48 rounded up to 91) giving the advantage of a low word counting from 0 to 2ⁿ-1.

According to an embodiment, the counting operation comprises: applying for each bit the same number of updates (in particular with respect to the low part/word; the high part/word may be considered separately). Thereby a highly efficient distribution by wear levelling may be achieved.

According to an embodiment, the counting operation comprises: counting a Gray code sequence during a first counting cycle and counting back said Gray code sequence during a second, in particular subsequent, counting cycle. This scheme may further decrease the number of required bits. As illustrated in Figure 1, a Gray code sequence (counting cycle) may e.g. include 8 values (increment). Then, the (same) Gray code sequence can be counted backwards (decrement), e.g. again 8 values (further counting cycle).

According to an embodiment, the method further comprising: performing a tearing-protection operation on bit-level. For example, such a bit protection may be implemented using atomic flags.

In an example, as Gray codes are being used, at each counter increment only one (payload) bit gets updated. By construction, the counter will either be incremented or not, if the update gets interrupted (torn). Still a torn update can/will cause weak bits, which may be difficult to detect.

Adding tearing protecting by defining a flag on top of the overall scheme may not work, as the endurance of the memory is a limitation to the number of possible updates of such a protection scheme. But tearing-protection can be done at bit-level and memories with bit-alterability can provide so-called "atomic" flags. Hereby, each logical bit would require three memory bits; hence, it triples the memory demand.

According to an embodiment, the tearing-protection operation may be performed by rewriting (refreshing) the last changed bit before updating the next bit. Hence, a tear protection with low memory demand may be provided in a straightforward manner.

In an example, as the counter is only meant to increment in steps of 1, it is always known, which bit was updated in the last (previous) counter update. Instead of trying to detect a potential tearing it might be acceptable that (after a tearing, but before next update) the counter might change when reading it more than once. If so, before incrementing the next time, the (known) lastly changed bit can get re-freshed (simply re-written) before updating the next bit. If torn at the re-fresh, the situation is like before. If the refresh succeeded, a potential previous tearing is resolved.

Formally, the re-fresh subtracts one update from the endurance budget. Whether such a refresh needs to be counted or not, may depend on the technology. But even if it must be counted, the effective endurance which can be used for the counter may be reduced by a factor of two. This may roughly double the memory demand. But doubling the memory demand may still be advantageous compared to a triple memory demand. If the use-case of the counter is normally causing many updates after the system has booted, a normal single flip flop could be used to cause the refresh only on the first counter increment after booting the system. Without a tearing, there may be no need to refresh the last update. Hence, the refresh may normally be skipped if it is known that no tearing (which would cause a re-boot) occurred.

According to an embodiment, the counter operates in a non-volatile storage/memory (environment) with individual bit update in at least one direction (in particular in both directions). In an embodiment, the non-volatile memory comprises at least one of: RRAM, MRAM, PC-Ram, FE-RAM. Thus, technically and economically important applications can be directly used for implementing the counter according to the disclosure. In an embodiment, especially when using Gray code, the non-volatile memory may be free of a memory that does not support individual bit update/deletion (in both directions), e.g. FLASH or EEPROM memory.

According to an embodiment, the disclosure may be implemented in hardware and/or software. A software implementation may allow for on-demand-scaling.

### BRIEF DESCRIPTION OF THE DRAWINGS

Figure 1 illustrates a counting operation using a combined Gray code and wear-levelling scheme, according to an exemplary embodiment of the disclosure.
Figure 2 illustrates memory demand in bits for a plurality of counting operations and compares a conventional binary counter with exemplary embodiments of the disclosure.

### DETAILED DESCRIPTION OF THE DRAWINGS

Before referring to the drawings, embodiments will be described in further detail, some basic considerations will be summarized based on which embodiments of the disclosure have been developed.

According to an exemplary embodiment, the disclosure proposes a method which uses Gray code with majority voting in a combination with an optimized wear levelling scheme to minimize the memory needs. In addition, the disclosure may provide means to realize a tear-safe implementation which increases memory needs again, but the proposed method achieves a lower increase than a conventional implementation by utilizing the specifics of a counter.

According to an exemplary embodiment, the disclosure may comprise at least one of the following features:
i) Split the counter into a high part and a low part. The high part can typically be realized without endurance problems, as the number of required updates is limited.
ii) The partial counters get implemented using Gray codes to minimize the number of total bit togglings per counter update.
iii) Error correction scheme replaced by majority voting.
iv) Wear-levelling (to meet memory endurance limitation) split into in-word wear-levelling by bit rotation and wear-levelling by moving to a new location.
v) Option to realize the counter updates in a tear-safe way.

According to an exemplary embodiment, an aspect of the disclosure may be described as follows: wear-levelling to cope with endurance limitations is normally done on large data portions (like a full Flash page). Smaller objects with high update frequency need special handling and typically handled by placing a word-sized (e.g. 32 bit) together with meta data at multiple locations of a page (e.g. 4096 bits). Counters (e.g. used for time stamps) have special requirements (very high update frequency) and boundary conditions (systematic, but non-random data). Still, in conventional implementations, wear-levelling is still done on a memory-word basis, while according to the disclosure wear-levelling may be done within the word.

**Figure 1** illustrates a counting operation using a combined bit-wise counting (here Gray code) and wear-levelling scheme, according to an exemplary embodiment of the disclosure.

The left table illustrates the updates per counter increment; brackets are used to indicate unused locations. In this example, the following parameter are given from left to right:
Counter value: the counting operation counts from 0 to 143, thus 144 counter values are necessary.
v_high: the high part counts from 0 to 17.
high_word: is the bit-representation of the high part; high word uses a Gray code, only the least significant four bits are shown for clarity.
location: three locations (0, 1, 2) of the memory are used, distributed by wear-levelling.
direction: the Gray code sequence is here incremented or decremented (counting backwards).
rotation: bit position of the Gray code scheme is shifted from normal (0) to rotated (1 or 2).
low_word: is the bit-representation of the low part. The low(-word) part uses a 3-bit Gray code and three locations are used here for wear-levelling (low_word[0], low_word[1], and low_word[2].

The redundant storage for majority voting is not shown for better overview. Majority voting can be implemented for example by using the shown table three times separately. Thereby, the memory demand would increase around three times.

The right table counts the updates on the first instance low _word[0] of the low_word per bit position. Low_word[1] and low_word[2] get the same number of updates, when these are being actively used; for better readability, columns have been added to the table for these. Borders are used to highlight the updates. Summarizing the left table and the right table, 144 counter values are causing only 14 updates for all bits (each bit toggled 14 times) in the low_words, while only three locations are used for wear-levelling.

Mathematically, this embodiment can be described as follows:
Given parameters:

| | |
|---|---|
| c_max | max. counter value which shall get supported |
| e | endurance (at bit-level) |
| t | tolerance to bit-faults (1=1-bit tolerant, 2=2-bit tolerant) |

Derived values:

| | | |
|---|---|---|
| m | | majority voting scheme m = 2*t+1 |
| h_max | max. counter value of high word, h_max = 2*e (standard Gray code) | |
| w_h | width of high word (payload bits), w_h=ceil(log2(h_max)) | |
| l_max | max. counter value of low word, l_max=ceil(c_max/h_max) | |
| w_l | width of low word (payload bits), w_l=ceil(log2(l_max)) | |
| ru_rot | re-usage (wear-levelling) by rotation ru_rot=w_l | |
| e_l | endurance after ru_rot rotated re-usage of one low word instance, e_l = l_max | |
| ru_loc | max. re-usage of each location, ru_loc=floor(e/e_l) | |
| ru_total | total re-usage of each low word instance ru_total=ru_loc*ru_rot | |
| n_loc | locations needed for wear-levelling n _loc=ceil(h_max/ru_total) | |
| bitcnt | total bit count (memory demand) bitcnt=m*(w_h+n_loc*w_l) | |
| nv_h[w_h-1:0] | NVM location storing the high word | |
| nv_l[w_l-1:0][n_loc-1:0] | NVM locations with n_loc entries (for wear-levelling) of the low word | |
| h_is_odd | nv_h[0] | |
| l_ptr | pointer to the currently active instance of nv_l | |
| | l_ptr = nv_h[w_h-1:1] mod n_loc | |
| l_rot | rotation of the current low word | |
| | l_rot = ((nv_h[w_h-1:1]-l_ptr)/ n_loc) mod w_l | |
| v_high | counter value of high word (after Gray-decoding) | |
| v_low | counter value of low word at the active location (after rotation and Gray-decoding) | |
| value | counter value: | |
| | if v_high is even: | value = v_high*l_max + v_low |
| | if v_high is odd: | value = v_high*l_max + (l_max - v_low) |

Initialization: high word and low word to all-0 condition.
Counting scheme:
If high word is even:
   If v_low < l_max-1: count active low word +1 according to rotated Gray scheme If v_low == l_max-1: count high word +1 according to Gray scheme
If high word is odd:
   If v_low > 0: count active low word -1 according to rotated Gray scheme If v_low == 0: count high word +1 according to Gray scheme

By doing so, only one update is needed per increment and at the re-use of any low word instance (rotated or re-visiting a location) will start from 0. The change in counting direction is actually identical to the standard Gray encoding when the next higher bit is being used.

### Reading the counter value:

| | |
|---|---|
| v_high | Gray-decoded value of high word: nv_h; this defines l_rot and l_ptr |
| v_low | Gray-decoded value of low word |
| | v_low = nv_l[w_l-1:0 rotated by l_rot][l_ptr] |

**Figure** 2 illustrates memory demand (expressed by bit requirements) for a plurality of counting operations and compares a conventional binary counter with exemplary embodiments of the disclosure. The uppermost table illustrates the following conditions which are considered: maximum needed counter value, maximum toggles per bit (i.e. endurance), and fault-tolerance (in bits). These are compared with the counter implementations discussed in this document, i.e.
i) a conventional binary counter with standard error correction (Hamming, BCH),
ii) a Gray code counter that uses majority voting, and
iii) a Gray code counter according to the disclosure that applies the optimized wear levelling (compare e.g. the example of Figure 1).

While the middle table does not apply tear protection, the lowermost table uses different tear protection schemes as described above, i.e. full bit protection (e.g. using atomic flags) and refreshing.

Throughout these example values, one can clearly see that the counter according to the disclosure may achieve a decrease in memory demand of around 80% in comparison to conventional approaches using a binary counter. This may come as a surprise since Gray code counting is generally considered as having a comparable memory demand as conventional binary counters.

## Claims

1. A computer-implemented method of operating a counter, the method comprising:
performing a counting operation, wherein the counting operation is done in a bit-wise manner;
splitting the counting operation using wear levelling; and
performing an error correction scheme with respect to the counting operation using majority voting.

2. The method according to claim 1,
wherein the counting operation comprises at least one of
Gray code,
Thermometer code.

3. The method according to one of the preceding claims, further comprising:
splitting the counter operation in a high part and a low part.

4. The method according to one of the preceding claims, comprising at least one of the following features:
wherein the majority voting comprises a single counting operation;
wherein the majority voting comprises using three or more bits per payload bit.

5. The method according to one of the preceding claims,
wherein the wear levelling comprises splitting the counting operation in two or more locations.

6. The method according to one of the preceding claims,
wherein the counting operation comprises a bit rotation scheme, so that a counting cycle uses a counting sequence, wherein at least one bit is different in comparison to the counting sequence of a previous counting cycle.

7. The method according to one of the preceding claims,
wherein the counting operation comprises: applying for each bit the same number of updates.

8. The method according to one of the preceding claims,
wherein the counting operation comprises: counting a counting sequence during a first counting cycle and counting back said counting sequence during a second counting cycle.

9. The method according to one of the preceding claims, further comprising:
performing a tearing-protection operation on bit-level using atomic flags.

10. The method according to one of the preceding claims, further comprising:
performing a tearing-protection operation by rewriting the last changed bit before updating the next bit.

11. The method according to one of the preceding claims,
wherein the counter operates at least partially in a non-volatile storage with individual bit update.

12. A counter device, comprising at least one logic circuit, configured to perform the method according to one of the preceding claims.

13. A device, comprising:
a non-volatile storage with individual bit update, and
a counter device according to claim 12, wherein the counter device is at least partially integrated in the non-volatile storage.

14. The device according to claim 13,
wherein the non-volatile storage is configured as one of the following: RRAM, MRAM, PC-Ram, FE-RAM.

15. Using a method according to one of the preceding claims 1 to 11 to reduce the memory demand of a counting operation.

## Amended claims

### Amended claims in accordance with Rule 137(2) EPC.

1. A computer-implemented method of operating a counter, the method comprising:
performing a counting operation, wherein the counting operation is done in a bit-wise manner;
splitting the counting operation in a high part and a low part using wear levelling; and
performing an error correction scheme with respect to the counting operation using majority voting;
wherein the counting operation comprises a bit rotation scheme inside the low part, so that a counting cycle uses a counting sequence, wherein at least one bit is different in comparison to the counting sequence of a previous counting cycle.

2. The method according to claim 1,
wherein the counting operation comprises at least one of
Gray code,
Thermometer code.

3. The method according to one of the preceding claims, comprising at least one of the following features:
wherein the majority voting comprises a single counting operation;
wherein the majority voting comprises using three or more bits per payload bit.

4. The method according to one of the preceding claims,
wherein the wear levelling comprises splitting the counting operation in two or more locations.

5. The method according to one of the preceding claims,
wherein the counting operation comprises: applying for each bit the same number of updates.

6. The method according to one of the preceding claims,
wherein the counting operation comprises: counting a counting sequence during a first counting cycle and counting back said counting sequence during a second counting cycle.

7. The method according to one of the preceding claims, further comprising:
performing a tearing-protection operation on bit-level using atomic flags.

8. The method according to one of the preceding claims, further comprising:
performing a tearing-protection operation by rewriting the last changed bit before updating the next bit.

9. The method according to one of the preceding claims,
wherein the counter operates at least partially in a non-volatile storage with individual bit update.

10. A counter device, comprising at least one logic circuit, configured to perform the method according to one of the preceding claims.

11. A device, comprising:
a non-volatile storage with individual bit update, and
a counter device according to claim 10,
wherein the counter device is at least partially integrated in the non-volatile storage.

12. The device according to claim 11,
wherein the non-volatile storage is configured as one of the following: RRAM, MRAM, PC-Ram, FE-RAM.

13. Using a method according to one of the preceding claims 1 to 9 to reduce the memory demand of a counting operation.
